# EUROPEAN PATENT APPLICATION

(11) **EP 2 466 646 A1**
(43) Date of publication of application: **20.06.2012**
(21) Application number: 10839136.8
(22) Date of filing: 29.11.2010
(51) Int. Cl.: H01L 31/04

(54) **APPARATUS FOR MANUFACTURING THIN-FILM LAMINATED BODY**

(30) Priority: 24.12.2009 JP 2009292278
(71) Applicant: Fuji Electric Co., Ltd., Kawasaki-shi Kanagawa 210-9530 (JP)
(72) Inventor: YOSHIDA, Takashi, Kawasaki-shi Kanagawa 210-9530 (JP); YOKOYAMA, Shoji, Kawasaki-shi Kanagawa 210-9530 (JP); YAMADA, Takanori, Kawasaki-shi Kanagawa 210-9530 (JP); NISHIZAWA, Masanori, Kawasaki-shi Kanagawa 210-9530 (JP); WADA, Takenori, Kawasaki-shi Kanagawa 210-9530 (JP)
(74) Representative: MERH-IP Matias Erny Reichl Hoffmann
(86) International application number: PCT/JP2010/071221
(87) International publication number: WO 2011/077901

(57) **Abstract**

Provided is an apparatus for manufacturing a thin film stacked member capable of improving the quality of the thin film stacked member by decreasing creases, heat wrinkles, and tension wrinkles in a film through wrinkle smoothing-out.

An apparatus for manufacturing a thin film stacked member by transporting a strip-shape flexible substrate in a horizontal direction with a width direction of the strip-shape flexible substrate as the vertical direction, transporting the strip-shape flexible substrate to a film deposition portion provided in a transport path of the strip-shape flexible substrate, and stacking a thin film on a surface of the strip-shape flexible substrate by means of a film deposition apparatus provided in the film deposition portion, wherein a temperature-raising portion 20 having a roller heater 21 is provided at least before the first of the film deposition portion 30, and a setting is made such that a temperature of the strip-shape flexible substrate 1 is raised by the roller heater 21 to approximately a temperature of the film deposition portion 30.

## Description

### TECHNICAL FIELD

This invention relates to an apparatus for manufacturing a thin film stacked member in which a film-shape flexible substrate is transported in a horizontal direction with its width direction as the vertical direction, that is in an upright state, and plasma discharge is caused by a high-frequency power supply in a gas atmosphere within a vacuum chamber to form a thin film, and relates to an apparatus for manufacturing a thin film stacked member having a mechanism of smoothing out, while transporting a thin film stacked member, heat wrinkles and tension wrinkles that occur during transporting the thin film stacked member while heating, and a wrinkle-smoothing mechanism which functions reliably even when the transport direction is reversed.

### BACKGROUND ART

A rigid substrate is normally used as the substrate of a semiconductor thin film or other thin film stacked member. However, as for example the substrate of a photoelectric conversion element used in solar cells and similar, a resin or other flexible substrate is used due to its light weight, ease of handling and other convenience, or in order to reduce costs through mass production.

As an apparatus to manufacture a thin film stacked member using such a flexible substrate, a film deposition apparatus has been developed which repeats an operation of passing a strip-shape flexible substrate through a plurality of film deposition chambers connected and arranged in a row and depositing film onto the surface of the flexible substrate in a halted state in each film deposition chamber, and an operation of then transporting the flexible substrate to the position of the next film deposition chamber, to stack a plurality of thin films with different properties on the flexible substrate (see for example Patent Reference 1).

Among such film deposition apparatuses, there are an apparatus type which holds width direction of the strip-shape flexible substrate in a horizontal direction and transports the flexible substrate in a horizontal direction to perform film deposition, and an apparatus type which holds the width direction of the strip-shape flexible substrate in a vertical direction, and transports the flexible substrate in a horizontal direction to perform film deposition. The latter type has such advantages over the former type as a decreased tendency for the flexible substrate surface to be contaminated; but as the number of film deposition chambers increases, there are the problems that wrinkles occur in the surface of the flexible substrate due to gravity and stretching of the flexible substrate, and that the flexible substrate tends to meander or droop downwards in the width direction.

In order to solve such problems, it has been proposed that an intermediate chamber be arranged between two film deposition chambers positioned in the center of numerous film deposition chambers arranged in a row, and that an edge position control (EPC) roller, which makes contact with the flexible substrate surface along the entire width-direction faces of the flexible substrate, be here provided. However, normally film deposition is performed at comparatively high temperatures, and so if such a stainless steel EPC roller were arranged between film deposition chambers, the flexible substrate would be rapidly cooled, and such problems as the occurrence of wrinkles would occur.

Hence a film deposition apparatus has been proposed in which a plurality of pairs of gripping rollers which sandwich the upper edge in the vertical direction of a strip-shape flexible substrate are provided in each interval between a plurality of film deposition chambers, and that the plurality of pairs of gripping rollers are installed with the rotation direction of each of the rollers inclined upward with respect to the direction of transport of the strip-shape flexible substrate (see Patent Reference 2 and Patent Reference 3).
By thus arranging, in each interval between the plurality of film deposition chambers, at least one pair of gripping rollers which sandwich the upper edge in the vertical direction of the strip-shape flexible substrate, and installing the plurality of pairs of gripping rollers such that the rotation direction of each of the rollers is inclined upward with respect to the direction of transport of the strip-shape flexible substrate, when the strip-shape flexible substrate is transported in the horizontal direction, a force raising the flexible substrate upward occurs. Hence even when the strip-shape flexible substrate is transported over a long distance between a plurality of film deposition chambers, the occurrence of wrinkles in the flexible substrate, meandering of the flexible substrate in the width direction, and drooping downward of the flexible substrate can be prevented, and the vertical-direction position of the strip-shape flexible substrate can be maintained with high precision.

Patent Reference 1: Japanese Patent Application Laid-open No. 2005-72408
Patent Reference 2: Japanese Patent Application Laid-open No. 2009-38276
Patent Reference 3: Japanese Patent Application Laid-open No. 2009-57632

However, in this technique of the prior art, the apparatus, which has as an object stretching-out during heating, grasps the edge of the strip-shape flexible substrate using pairs of gripping rollers before and after film deposition chambers, and smoothes out wrinkles. Consequently, when the temperature of the strip-shape flexible substrate falls, there is the problem that adequate smoothing-out of wrinkles is not performed.

An object of this invention is to provide an apparatus for manufacturing a thin film stacked member which resolves the above-described problems, and can improve the quality of the thin film stacked member by decreasing creases, heat wrinkles and tension wrinkles in a film through wrinkle smoothing-out.

### DISCLOSURE OF THE INVENTION

In order to resolve the above-described problems, this invention provides an apparatus for manufacturing a thin film stacked member by transporting a strip-shape flexible substrate in a horizontal direction with a width direction of the strip-shape flexible substrate as the vertical direction, transporting the strip-shape flexible substrate to a film deposition portion provided in a transport path of the strip-shape flexible substrate, and stacking a thin film on a surface of the strip-shape flexible substrate by means of a film deposition apparatus provided in the film deposition portion, wherein a temperature-raising portion having a roller heater is provided at least before the first of the film deposition portion, and a setting is made such that a temperature of the strip-shape flexible substrate is raised by the roller heater to approximately a temperature of the film deposition portion.
Further, in this invention a temperature-lowering portion having a roller heater is provided after the last of the film deposition portion, and a setting is made such that the strip-shape flexible substrate is heated by the roller heater at a temperature between the temperature within the film deposition portion and normal temperature.
Further, in this invention heating temperatures are set using the roller heater provided in the temperature-raising portion and the roller heater provided in the temperature-lowering portion, and a setting is made such that functions of the roller heaters are switched between the roller heater for the temperature-raising portion and the roller heater for the temperature-lowering portion, depending on a direction of transport of the strip-shape flexible substrate.
Further, in this invention, pairs of gripping rollers which respectively sandwich upper and lower edges in the vertical direction of the strip-shape flexible substrate are provided in a previous stage of each of the roller heaters, and a setting is made such that the strip-shape flexible substrate is stretched out in the width direction and transported by means of these gripping rollers and wrinkles in the strip-shape flexible substrate are smoothed out by means of the roller heaters.
Further, pairs of gripping rollers which respectively sandwich upper and lower edges in the vertical direction of the strip-shape flexible substrate are provided before and after the film deposition portion, and a setting is made such that, wrinkles in the strip-shape flexible substrate that occur at the time of film deposition are smoothed out by means of these gripping rollers.

According to Claim 1, by heating a strip-shape flexible substrate prior to entry into a film deposition portion using the roller heater in a temperature-raising portion so that the temperature of the strip-shape flexible substrate is approximately the temperature of the film deposition portion, wrinkles can easily be smoothed out.
According to Claim 2, the strip-shape flexible substrate on which film deposition has been performed by the film deposition portion can be gradually cooled, so that the occurrence of wrinkles due to rapid cooling can be prevented.
According to Claim 3, heating temperatures can be set using the roller heater of the temperature-raising portion and the roller heater of the temperature-lowering portion, so that at the time of supply to a film deposition portion, the substrate can be supplied while heating the strip-shape flexible substrate to a temperature near that of the film deposition portion, and rapid cooling after exiting from the film deposition portion can be prevented. Further, when transporting the strip-shape flexible substrate in both directions, by interchanging the roles of the temperature-raising portion and the temperature-lowering portion, transport in both directions becomes possible.
According to Claim 4, by means of gripping rollers, the strip-shape flexible substrate can be stretched out in the width direction and transported, so that there is no concern that wrinkles may be created in the strip-shape flexible substrate by roller heaters.
According to Claim 5, by means of gripping rollers, wrinkles can be smoothed out during film deposition on the strip-shape flexible substrate, so that the occurrence of wrinkles during film deposition can be prevented.

### BRIEF DESCRIPTION OF THE DRAWINGS

Fig. 1 is a plane view schematically showing an embodiment of an apparatus for manufacturing thin film stacked members of this invention;
Fig. 2 is a perspective view schematically showing the film deposition portions of Fig. 1;
Fig. 3 is a perspective view showing the upper and lower gripping rollers of Fig. 2;
Fig. 4 is a perspective view schematically showing a gripping roller angle adjustment mechanism;
Fig. 5 is a front view showing the gripping roller angle adjustment mechanism of Fig. 4;
Fig. 6 is a plane view schematically showing another embodiment of an apparatus for manufacturing thin film stacked members of this invention;
Fig. 7 is a plane view schematically showing still another embodiment of an apparatus for manufacturing thin film stacked members of this invention; and
Fig. 8 is a perspective view showing upper and lower gripping rollers when the transport direction is reversed.

### BEST MODE FOR CARRYING OUT THE INVENTION

Below, a detailed explanation of embodiments is given, referring to the drawings.

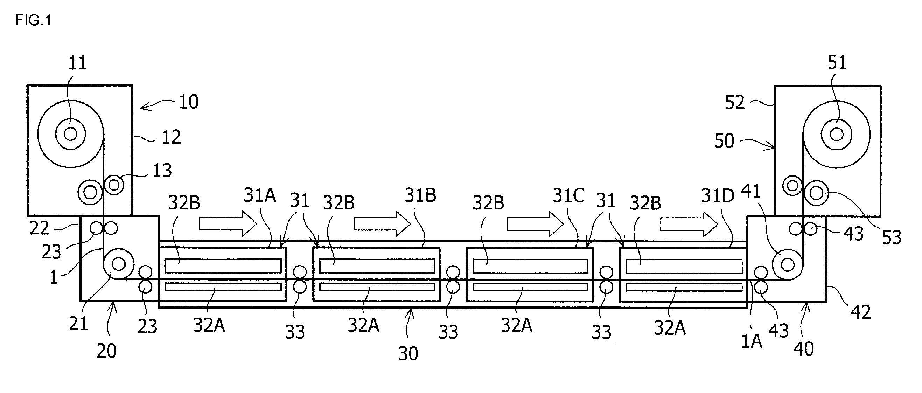

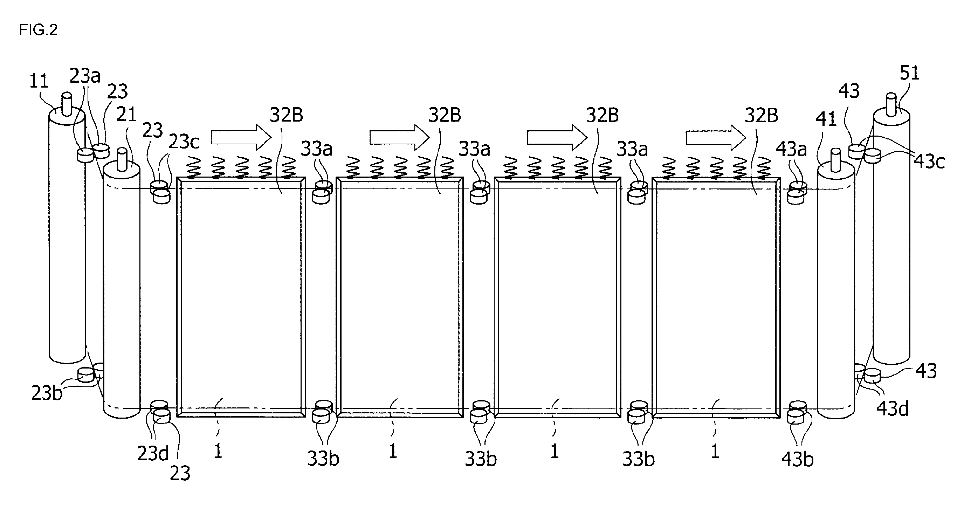

Fig. 1 and Fig. 2 show one embodiment of an apparatus for manufacturing thin film stacked members, which is a roll-to-roll type plasma CVD apparatus which continuously deposits thin film layers of an amorphous solar cell.
The apparatus for manufacturing thin film stacked members of Fig. 1 and Fig. 2 employs a single-direction transport method, and comprises an unwinding portion 10 which incorporates a strip-shape flexible substrate 1 wound in roll form; a temperature-raising portion 20 which heats the strip-shape flexible substrate 1 to approximately the temperature of the film deposition portion 30; a film deposition portion 30, comprising a plurality of film deposition chambers 31 which form thin film layers on the strip-shape flexible substrate 1; a temperature-lowering portion 40, which heats the strip-shape flexible substrate 1 on which solar cell thin film layers have been deposited so that the temperature of the thin film stacked member does not fall rapidly; and a takeup portion 50 which takes up the deposited thin film stacked member 1A.

The unwinding portion 10 houses in a housing chamber 12 a vertical-direction roller 11 on which is wound, in roll form, a strip-shape flexible substrate 1 with its width direction as the vertical direction; in the housing chamber 12 is provided a pair of auxiliary rollers 13 which pull out the strip-shape flexible substrate 1 and feed the vertically oriented strip-shape flexible substrate 1 in a horizontal direction. Although not shown in the figures, normally a plurality of guide rollers are provided together with the auxiliary rollers 13 in the housing chamber 12.

The temperature-raising portion 20 comprises a temperature-raising chamber 22 in which is arranged a vertical-direction roller heater 21 as a heating apparatus; this temperature-raising chamber 22 is provided between the housing chamber 12 and the film deposition portion 30, and heats and transports the strip-shape flexible substrate 1 pulled out from the unwinding portion 10 while changing the direction in substantially a right-angle direction as seen in plane view. In the temperature-raising chamber 22, before the strip-shape flexible substrate 1 enters the film deposition portion 30, heating is performed by the roller heater 21 until the temperature of the strip-shape flexible substrate 1 is substantially at the temperature of the film deposition portion 30.

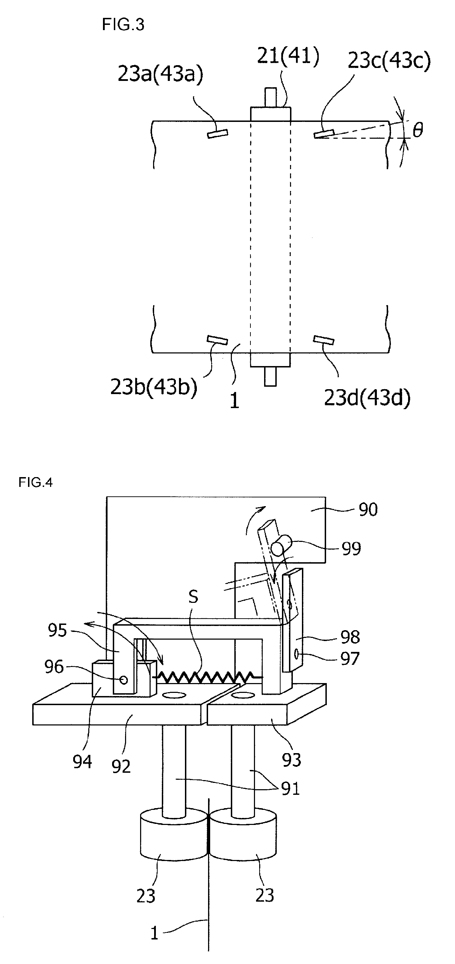

As shown in Fig. 3, pairs of gripping rollers 23 (23a, 23b and 23c, 23d) are provided both before and after the roller heater 21 in the temperature-raising chamber 22 to sandwich the upper end and lower end of the strip-shape flexible substrate 1. The upper gripping rollers 23a, 23c are installed with the roller rotation direction inclined upward with respect to the direction of transport of the strip-shape flexible substrate 1 (that is, the horizontal direction). In this way, by setting an angle θ between the rotation direction of the upper gripping rollers 23a, 23c and the direction of transport of the strip-shape flexible substrate 1, when the strip-shape flexible substrate 1 is transported in the horizontal direction, a force raising the strip-shape flexible substrate 1 upward occurs. The lower gripping rollers 23b, 23d are installed with the roller rotation direction inclined downward with respect to the direction of transport of the strip-shape flexible substrate 1 (that is, the horizontal direction).

In the film deposition portion, a plurality of film deposition chambers 31A to 31D (four chambers in the example shown) are arranged in a row along the transport direction, and the interiors of the chambers, in a vacuum, are filled with reactive gas. Within the plurality of film deposition chambers 31A to 31D are provided, as film deposition apparatuses, mutually opposed high-frequency electrodes 32A and grounded electrodes 32B with internal plate heaters. A high-frequency power supply, not shown, is connected to the high-frequency electrodes 32A, and by applying a high-frequency power supply, plasma discharge is caused in the space formed between the high-frequency electrodes 32A and the grounded electrodes 32B. By means of the plasma occurring between the high-frequency electrodes 32A and the grounded electrodes 32B, the reactive gas in the film deposition chambers 31A to 31D is decomposed, and a thin film is formed on the surface of the strip-shape flexible substrate 1 positioned between the high-frequency electrodes 32A and the grounded electrodes 32B. In this case, thin films with different properties can also be formed in each of the film deposition chambers 31A to 31D. For example, in three film deposition chambers 31, N-type layer, I-type layer, and P-type layer thin films can be formed in succession. In each of the intervals between the plurality of film deposition chambers 31A to 31D are arranged a pair of gripping rollers 33 (33a, 33b) which sandwich and transport the upper edge and lower edge respectively of the strip-shape flexible substrate 1.
The upper grip rollers 33a, similarly to the upper gripping rollers 23a in the temperature-raising chamber 22, are installed with the roller rotation direction inclined upward with respect to the transport direction of the strip-shape flexible substrate 1 (that is, the horizontal direction). And the lower gripping rollers 33b are also installed inclined downward, similarly to the lower gripping rollers 23b in the temperature-raising chamber 22.

The temperature-lowering portion 40 comprises a temperature-lowering chamber 42 in which is arranged a vertical-direction roller heater 41 as a heating apparatus; this temperature-lowering chamber 42 is provided between the film deposition portion 30 and the takeup portion 50, and heats and transports the strip-shape flexible substrate 1 while changing the direction in substantially a right-angle direction as seen in plane view.

As shown in Fig. 3, in this temperature-lowering chamber 42 are provided pairs of gripping rollers 43 (43a, 43b and 43c, 43d) are provided both before and after the roller heater 41 to sandwich and transport the upper edge and lower edge of the strip-shape flexible substrate 1. The upper gripping rollers 43a, 43c are installed with the roller rotation direction inclined upward with respect to the direction of transport of the strip-shape flexible substrate 1 (that is, the horizontal direction). In this way, by setting an angle θ between the rotation direction of the upper gripping rollers 43a, 43c and the direction of transport of the strip-shape flexible substrate 1, when the strip-shape flexible substrate 1 is transported in the horizontal direction, a force raising the strip-shape flexible substrate 1 upward occurs. The lower gripping rollers 43b, 43d are installed with the roller rotation direction inclined downward with respect to the direction of transport of the strip-shape flexible substrate 1 (that is, the horizontal direction).

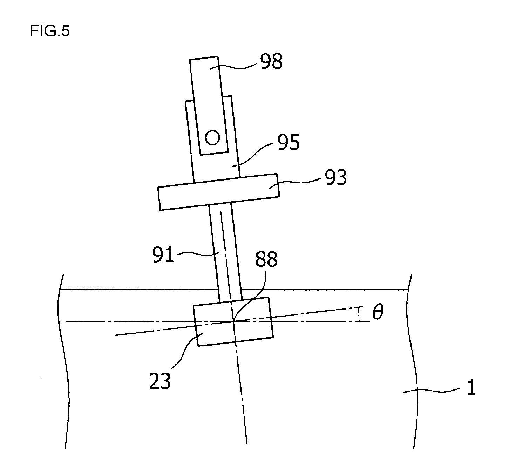

An example of a mechanism to incline the gripping rollers 23 (43) is explained, applied to the upper gripping rollers 23 (43), using Fig. 4 and Fig. 5. Gripping rollers 23 are rotatably supported by the lower ends of roller fixing shafts 91. The upper end of a roller fixing shaft 91 is fixed to the lower face of a roller fixing portion 92, and the upper end of the other roller fixing shaft 91 is fixed to the lower face of a roller moving portion 93. A rotation support portion 94 is provided on the upper face of the roller fixing portion 92, and one end of a U-shape handle portion 95 is provided on the upper face of the roller moving portion 93. The other end of the handle portion 95 is rotatably fixed to the rotation support portion 94 with a hinge 96 as a fulcrum. And, by causing rotation of the roller moving portion 93 with the hinge 96 as fulcrum, the strip-shape flexible substrate 1 can be sandwiched between the gripping rollers 23, and the distance between the gripping rollers 23 can be increased. The rotation support portion 94 and the other-end side of the handle portion 95 are connected by a tension spring S, and when in a state in which the strip-shape flexible substrate 1 is sandwiched between the gripping rollers 23, the length of the tension spring S is shortest. The pressure applied by the gripping rollers 23 to the strip-shape flexible substrate 1 can be adjusted through the strength of the tension spring S.

One end of a lever 98 is rotatably mounted on the other-end side of the handle portion 95, with a hinge 97 as a fulcrum. The rotation shaft of the hinge 97 is perpendicular to the rotation shaft of the hinge 96. The roller fixing portion 92 is fixed to the surface of a fixing plate 90, and a protruding bar 99 is provided on the surface of this fixing plate 90. This bar 99 is positioned in the path of the other end of the lever 98 when the handle 95 is caused to rotate with the hinge 96 as a fulcrum. That is, the bar 99 is in a position to make contact with the other end of the lever 98 and impede rotation of the handle 95. Further, when the lever 98 is rotated with the hinge 97 as a fulcrum and the other end of the lever 98 moves past the bar 99, the handle 95 can rotate freely.

As shown in Fig.5, the gripping rollers 23, 43 are installed with the roller rotation direction inclined upward with respect to the transport direction of the strip-shape flexible substrate 1. The angle 6 between the roller rotation direction and the substrate transport direction may be fixed at a certain constant angle, or it may be possible to change the angle even during film deposition. When changing the angle θ, it is preferable that a configuration be employed such that angle adjustment is performed with the center points 88 of the rotation shafts of the gripping rollers 23, 43 as fulcrums. By making the center points 88 the fulcrums, the occurrence of wrinkles in the substrate 1, and meandering of the substrate 1, can be prevented. In particular, it is preferable that angle adjustment be made possible for gripping rollers 43 positioned consecutively on the upper sides of the plurality of pairs. By this means, the transport height of the substrate 1 can be precisely adjusted to the initial height serving as reference.

The configuration of the upper gripping rollers 23a and auxiliary apparatus thereof have been explained; the lower gripping rollers 23b and auxiliary apparatus thereof are vertically inverted, but can have a similar configuration. Further, the gripping rollers 43, a plurality of pairs of which are provided consecutively, can also have a similar configuration. It is preferable that gripping rollers be fabricated from silicone rubber, fluoride rubber, or another heat-resistant rubber, PTFE, a polyimide or another synthetic resin. Prescribed performance can be obtained even when the material is stainless steel or iron with a chromium plating.

In the takeup portion 50, a vertical-direction takeup roller 51, which takes up in roll form the strip-shape flexible substrate 1 with its width direction as the vertical direction, is housed in a housing chamber 52; in the housing chamber 52 is provided a pair of auxiliary rollers 53 which send the strip-shape flexible substrate 1 to the takeup roller 51. Although not shown in the figures, normally a plurality of guide rollers are provided together with the auxiliary rollers 53 in the housing chamber 52.

To explain the action in the above-described embodiment, the strip-shape flexible substrate 1 is pulled out from the roller 11 and transported in the horizontal direction with its width direction as the vertical direction. The strip-shape flexible substrate 1 is sent to the temperature-raising chamber 22, and is heated by the roller heater 21 to approximately the temperature of the film deposition portion 30. When raising the temperature using the roller heater 21, heat wrinkles occur due to an uneven temperature distribution. These heat wrinkles occur due to differences in the linear expansion coefficient caused by temperature. The strip-shape flexible substrate 1 sent to the temperature-raising chamber 22 is stretched by the pairs of gripping rollers 43a, 43b before directly raising the temperature by the roller heater 21, and in this stretched state is heated by the roller heater 21. Through heating, tension wrinkles occur in the stretched strip-shape flexible substrate 1. These tension wrinkles are smoothed out by the next pairs of gripping rollers 23c, 23d, before sending to the film deposition portion 30.

The strip-shape flexible substrate 1 sent to the film deposition portion 30 is held at constant distances from the high-frequency electrodes 32A and grounded electrodes 32B within the film deposition chambers 31A to 31D. The grounded electrodes 32B are heated to a constant temperature by internal heaters. And by means of the high-frequency power applied to the high-frequency electrodes 32A, plasma discharge with the grounded electrodes 32B occurs, and by means of this plasma the reactive gas within the film deposition chambers 31A to 31D is decomposed, and stable thin films are formed on the surface of the strip-shape flexible substrate 1 positioned between the high-frequency electrodes 32A and the grounded electrodes 32B.

And, the thin film stacked member 1A, in which thin films formed on the surface of the strip-shape flexible substrate 1, is sent to the temperature-lowering portion 40, where tension wrinkles which had occurred in the film deposition chambers 31A to 31D of the film deposition portion 30 are smoothed out by the pairs of gripping rollers 43a, 43b, after which heating is again performed by the roller heater 41 to a temperature lower than that of the roller heater 21. In this way wrinkles which would occur upon rapid cooling after exit from the film deposition portion 30 are prevented. Then, after passing the roller heater 41, wrinkles occurring due to cooling are smoothed out by the pairs of gripping rollers 43c, 43d, after which the thin film stacked member 1A is sent to the takeup portion 50. At this time, wrinkles may also occur due to an uneven temperature distribution; these wrinkles also occur due to differences in linear expansion coefficient caused by temperature.

The thin film stacked member 1A sent to the takeup portion 50 is braked by the auxiliary roller 53 and taken up by the roller 51 within the housing chamber 52 while being pulled.

As explained above, the temperature of the strip-shape flexible substrate 1 sent to the film deposition portion 30 is raised to approximately the same temperature as the film deposition portion 30 by the roller heater 21, and heat wrinkles occurring due to an uneven temperature distribution are smoothed out by the pairs of gripping rollers 23c, 23d disposed in the previous stage of the film deposition portion 30. And, after the film deposition portion 30, the strip-shape flexible substrate 1 is heated by the roller heater 41 to a temperature lower than that of the roller heater 21, and the heat wrinkles occurring at this time are smoothed out by the pairs of gripping rollers 43a, 43b, so that heat wrinkles occurring in the strip-shape flexible substrate 1 can be decreased.

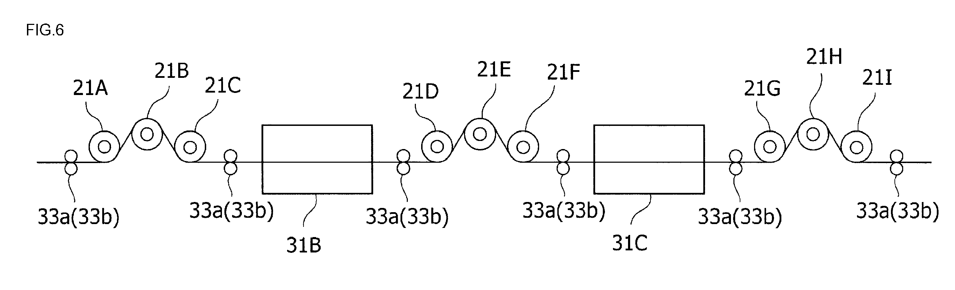

Next, Fig. 6 explains another embodiment of the invention, with portions which are the same as in Fig. 1 assigned the same symbols and explanations omitted.
Within the film deposition chambers 31A to 31D of the film deposition portion 30 shown in Fig. 1 are arranged, between film deposition chamber 31A and film deposition chamber 31B, between film deposition chamber 31B and film deposition chamber 31C, and between film deposition chamber 31C and film deposition chamber 31D, the roller heaters 21A to 21C, 21D to 21F, and 21G to 211. The roller heaters 21A to 21C, 21D to 21F, and 21G to 211 are arranged such that the positions of the roller heaters 21B, 21E and 21H arranged in respective intermediate positions are shifted in a direction perpendicular to the lines connecting the roller heaters 21A and 21C, 21D and 21F, and 21G and 211, so as to smooth out heat wrinkles in the strip-shape flexible substrate 1. And, pairs of gripping rollers 33a, 33b which sandwich and transport the upper edge and lower edge of the strip-shape flexible substrate 1 are arranged before and after the roller heaters 21A to 21C, 21D to 21F, and 21G to 211.

In this way, after leaving each of the film deposition chambers 31A to 31C, the strip-shape flexible substrate 1 is again heated by the roller heaters 21A to 21C, so that the occurrence of wrinkles due to cooling after leaving the film deposition chambers 31A to 31C can be prevented.

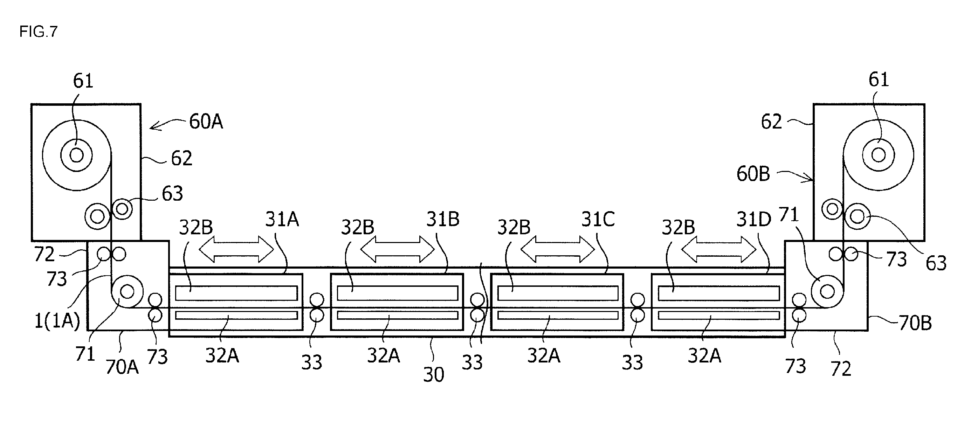

The apparatus for manufacturing thin film stacked members of Fig. 7 is a bi-directional transport apparatus, and the same portions as in Fig. 1 are assigned the same symbols in explanations.
In this case, unwinding/takeup portions 60A, 60B, which can both unwind and take up the strip-shape flexible substrate 1, are arranged on both sides of the film deposition portion 30 of Fig. 1.
That is, unwinding/takeup portions 60A, 60B in which vertical-direction rollers 61 are housed in housing chambers 62, a film deposition portion 30 provided between the unwinding/takeup portions 60A, 60B and comprising film deposition chambers 31A to 31D which form thin film layers on a strip-shape flexible substrate 1, and temperature-raising/lowering portions 70A, 70B arranged between the unwinding/takeup portions 60A, 60B and the film deposition portion 30, are comprised.

Within the unwinding/takeup portions 60A, 60B, the strip-shape flexible substrate 1 wound in roll form is included within the housing chamber 62 on the unwinding side, and the strip-shape flexible substrate 1 is fed out, or is taken up, by auxiliary rollers 63 provided at the housing chamber 62.

The temperature-raising/lowering portions 70A, 70B comprise temperature raising/lowering chambers 72 in which are arranged vertical-direction roller heaters 71 as heating apparatuses. The temperature raising/lowering chambers 72 are provided between the housing chambers 62 and the film deposition chambers 31A to 31D, and heat and transport the strip-shape flexible substrate 1 drawn out from the unwinding/takeup portions 60A, 60B, while changing the direction in substantially a right-angle direction as seen in plane view.
Further, the temperature-raising/lowering chambers 72 is used for heating and transporting, by means of the roller heaters 71, the thin film stacked member 1A sent from the film deposition chambers 31A to 31D, while changing the direction in substantially a right-angle direction as seen in plane view.
In the temperature-raising/lowering chambers 72 are provided pairs of gripping rollers 73 before and after the roller heaters 71 which sandwich and transport both the upper edge and lower edge of the strip-shape flexible substrate 1.

In this embodiment, when for example the strip-shape flexible substrate 1 is unwound from the unwinding/takeup portion 60A, the temperature-raising/lowering portion 70A functions similarly to the temperature-raising portion 20 of Fig. 1, and the temperature-raising/lowering portion 70B functions similarly to the temperature-lowering portion 40 of Fig. 1. That is, in the temperature-raising/lowering portion 70A, the strip-shape flexible substrate 1 is heated by the roller heater 71 to a temperature which is approximately the temperature of the film deposition portion 30.
Before and after the roller heater 71, pairs of gripping rollers 73 which sandwich and transport the upper edge and lower edge of the strip-shape flexible substrate 1 transport the strip-shape flexible substrate 1 to the film deposition portion 30, while smoothing out wrinkles which have occurred in the strip-shape flexible substrate 1.

After being transported to the film deposition portion 30, the strip-shape flexible substrate 1 is formed with thin films in order while being sent to each of the film deposition chambers 31A to 31D.

Next, the thin film stacked member 1A is transported to the temperature-raising/lowering portion 70B, and while being heated by the roller heater 71 to a temperature lower than that of the temperature-raising/lowering portion 70A, is taken up by the roller 61 of the unwinding/takeup portion 60B. At this time during transporting, wrinkles which have occurred in the flexible substrate 1 are pulled upward and downward and smoothed out by the upper-side gripping rollers 73 and lower-side gripping rollers 73 provided in the temperature-raising/lowering portion 70B.

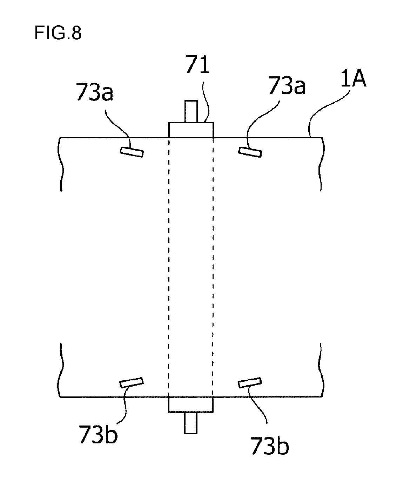

The thin film stacked member 1A which has been taken up by the roller 61 of the unwinding/takeup portion 60B is now pulled out in the opposite direction, entering the film deposition portion 30 from the temperature-raising/lowering portion 70B, and the next thin film is formed on the surface of the thin film stacked member 1A by plasma discharge between the high-frequency electrodes 32A and the grounded electrodes 32B in each of the film deposition chambers 31A to 31D. At this time also, in the temperature-raising/lowering portion 70B, heating is performed by the roller heater 71 to approximately the same temperature as the film deposition portion 30, and wrinkles occurring due to heating are pulled upward and downward and smoothed out by the upper-side gripping rollers 73a and lower-side gripping rollers 73b. At this time, as shown in Fig. 8, the directions of the upper-side gripping rollers 73a and lower-side gripping rollers 73b are inclined opposite the directions shown in Fig. 3. In this way, the thin film stacked member 1A on which thin films are formed in succession in the film deposition chambers 31A to 31D of the film deposition portion 30 is transported to the temperature-raising/lowering portion 70A. In the temperature-raising/lowering portion 70A, heating is performed by the roller heater 71 to a temperature lower than that of the temperature-raising/lowering portion 70B, and wrinkles occurring due to heating are pulled upward and downward and smoothed out by the upper-side gripping rollers 73a and lower-side gripping rollers 73b, before takeup by the roller 61 of the unwinding/takeup portion 60A. In this way, while being transported in both directions, a thin film stacked member on which prescribed thin films are formed is manufactured.

As explained above, by means of the above-described embodiment, wrinkles such as creases, heat wrinkles, and tension wrinkles occurring in the strip-shape flexible substrate 1 are decreased by being smoothed out by the roller heaters 71 and gripping rollers 73a and 73b, so that a thin film stacked member 1A of good quality can be manufactured.

This invention is not limited to the above-described embodiments, and for example the temperatures of the roller heaters 21, 41, 71 arranged in the temperature-raising portion 20, temperature-lowering portion 40, and temperature-raising/lowering portions 70A and 70B can be set appropriately. The gripping rollers 23a, 23b, 23c, 23d, 43a, 43b, 43c, 43d, 73a, 73b arranged before and after the roller heaters 21, 41, 71 can be arranged inclined at an appropriate angle suitable for smoothing wrinkles. In addition, various appropriate modifications and alterations can of course be made without deviating from the gist of the invention.

### EXPLANATION OF REFERENCE NUMERALS

- 1: Strip-shape flexible substrate
- 10: Unwinding portion
- 11, 51: Roller
- 12, 52: Housing chamber
- 13, 53: Auxiliary roller
- 20: Temperature-raising portion
- 30: Film deposition portion
- 32A: High-frequency electrode (film deposition apparatus)
- 32B: Grounded electrode (film deposition apparatus)
- 40: Temperature-lowering portion
- 50: Takeup portion
- 23a, 23b, 23c, 23d, 43a, 43b, 43c, 43d, 73a, 73b: Gripping roller
- 21, 41, 71: Roller heater (heating apparatus)

## Claims

1. An apparatus for manufacturing a thin film stacked member by transporting a strip-shape flexible substrate in a horizontal direction with a width direction of the strip-shape flexible substrate as the vertical direction, transporting the strip-shape flexible substrate to a film deposition portion provided in a transport path of the strip-shape flexible substrate, and stacking a thin film on a surface of the strip-shape flexible substrate by means of a film deposition apparatus provided in the film deposition portion,
wherein a temperature-raising portion having a roller heater is provided at least before the first of the film deposition portion, and a setting is made such that a temperature of the strip-shape flexible substrate is raised by the roller heater to approximately a temperature of the film deposition portion.

2. The apparatus for manufacturing a thin film stacked member according to Claim 1, wherein a temperature-lowering portion having a roller heater is provided after the last of the film deposition portion, and a setting is made such that the strip-shape flexible substrate is heated by the roller heater at a temperature between the temperature within the film deposition portion and normal temperature.

3. The apparatus for manufacturing a thin film stacked member according to Claim 2, wherein heating temperatures are set using the roller heater provided in the temperature-raising portion and the roller heater provided in the temperature-lowering portion, and a setting is made such that functions of the roller heaters are switched between the roller heater for the temperature-raising portion and the roller heater for the temperature-lowering portion, depending on a direction of transport of the strip-shape flexible substrate.

4. The apparatus for manufacturing a thin film stacked member according to any one of Claims 1 to 3, wherein pairs of gripping rollers which respectively sandwich upper and lower edges in the vertical direction of the strip-shape flexible substrate are provided in a previous stage of each of the roller heaters, and a setting is made such that the strip-shape flexible substrate is stretched out in the width direction and transported by means of these gripping rollers, and wrinkles in the strip-shape flexible substrate are smoothed out by means of the roller heaters.

5. The apparatus for manufacturing a thin film stacked member according to any one of Claims 1 to 4, wherein pairs of gripping rollers which respectively sandwich upper and lower edges in the vertical direction of the strip-shape flexible substrate are provided before and after the film deposition portion, and a setting is made such that wrinkles in the strip-shape flexible substrate that occur at the time of film deposition are smoothed out by means of these gripping rollers.
